(19) **Europäisches Patentamt**

**European Patent Office**

**Office européen des brevets**

(11) **EP 0 639 906 B1**

(12) **EUROPÄISCHE PATENTSCHRIFT**

(45) Veröffentlichungstag und Bekanntmachung des Hinweises auf die Patenterteilung:
**25.09.2002 Patentblatt 2002/39**

(51) Int Cl.$^7$: **H04L 7/027**, H03M 7/00

(21) Anmeldenummer: **94111861.4**

(22) Anmeldetag: **29.07.1994**

(54) **Digitaler Abtastratenumsetzer**

Digital sampling converter

Convertisseur pour échantillonnage numérique

(84) Benannte Vertragsstaaten:
**DE ES FR GB IT**

(30) Priorität: **06.08.1993 DE 4326427**

(43) Veröffentlichungstag der Anmeldung:
**22.02.1995 Patentblatt 1995/08**

(73) Patentinhaber: **DEUTSCHE THOMSON-BRANDT GMBH**
**78048 Villingen-Schwenningen (DE)**

(72) Erfinder:
• **Schemmann, Heinrich**
**D-78048 Villingen-Schwenningen (DE)**
• **Rothermel, Karin**
**D-78048 Villingen-Schwenningen (DE)**

(56) Entgegenhaltungen:
EP-A- 0 084 945  DE-C- 3 803 446
US-A- 4 106 053  US-A- 5 199 046

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen digitalen Abtastratenumsetzer zur Signalübertragung zwischen unterschiedliche Abtastraten bzw. Abtastfrequenzen verwendenden Geräten bzw. zur digitalen Abtastratenumsetzung eines digitalen Eingangssignals einer ersten Abtastrate in ein digitales Ausgangssignal einer zweiten Abtastrate.

Geräte und Systeme, die Audio- und/oder Videosignale in digitaler Form übertragen, verarbeiten oder speichern, finden zunehmend Verbreitung. Um eine Signalübertragung zwischen unterschiedlichen derartiger Geräte vornehmen zu können, ist ein Abtastratenumsetzer erforderlich, wenn die Geräte Schnittstellen mit unterschiedlichen Abtastraten aufweisen. In der Digitaltechnik ist die Abtastrate bzw. die Abtastfrequenz, mit der ein analoges oder auch digitales Signal abgetastet wird, eine der wichtigsten Systemeigenschaften. Sie gibt an, wie schnell die einzelnen Abtastwerte aufeinanderfolgen und wird auch als Sampling-Frequenz bezeichnet. Um den vollen Informationsgehalt eines analogen Signals zu erfassen, wird die Abtastfrequenz gemäß dem in der Praxis bewiesenen Shannonschen Abtasttheorem mindestens doppelt so hoch wie die zu messende Frequenz gewählt. Audiosignale im Frequenzbereich bis 20kHz würden somit eine Abtastfrequenz von 40 kHz erfordern. Für die einzelnen Aufzeichnungsträger und Übertragungsverfahren wurden jedoch unterschiedliche Abtastfrequenzen festgelegt. So beträgt beispielsweise die Abtastfrequenz:

    44,1 kHz bei der Compact-Disc,
    48 kHz beim Digital Audio Tape und
    32 kHz beim Satellitenrundfunk.

Zur Verarbeitung von Signalen eines Systems mit einer ersten Abtastfrequenz in einem System mit einer zweiten Abtastfrequenz ist ein Abtastratenumsetzer erforderlich, um aufgrund der sich durch die Frequenzen unterscheidenden Abtastzeitpunkte im Raster der zweiten Abtastfrequenz Abtastwerte bereitzustellen, die dem analogen Signal zu diesem Zeitpunkt möglichst genau entsprechen. Hierzu stehen grundsätzlich zwei Wege zur Verfügung. Entweder wird das digitale Signal in ein analoges Signal umgewandelt und das umgewandelte analoge Signal mit einer zweiten Abtastfrequenz wieder in ein digitales Signal umgewandelt oder es wird eine Umwandlung in der digitalen Ebene_vorgenommen. Die Abtastfrequenzumsetzung über eine analoge Zwischenstufe führt jedoch meist zu Qualitätsverlusten und erfordert aufwendige D/A- und A/D-Umsetzer sowie den mit Analog-Schaltungen im Zusammenhang stehenden notwendigen Abgleich. Insbesondere ist davon auszugehen, daß die zwischengeschaltete Analogstufe und die mehrfache Nutzung von Filtern die wesentlichen Vorteile der digitalen Signalverarbeitung zunichte machen, vgl. KRIEG, Bernhard: Praxis der digitalen Audiotechnik. In: Franzis-Arbeitsbuch 1989, S. 33.

Weiterhin sind Verfahren zur digitalen Abtastratenumsetzung bekannt, die jedoch nur mit relativ hohem Aufwand und einer Vielzahl von Schaltkreisen zu realisieren sind, wenn das Verhältnis zwischen ursprünglicher Frequenz und Zielfrequenz nicht ganzzahlig ist. In diesen Fällen wird eine sehr hohe Umsetzzwischenfrequenz benötigt. Insbesondere das Realisieren der erforderlichen Filter durch Berechnung der Filterkoeffizienten stellt einen hohen Aufwand dar, da die Filter mehrstufig sind und die Anzahl der notwendigen Koeffizientensätze proportional mit der Zwischenfrequenz wächst.

Diese Verfahren ermöglichen es weiterhin nicht, mit einer Schaltung unterschiedliche Zielfrequenzen zu wählen, vgl. LAGEDEC, R.:Digital Sampling Frequency Conversion in Digital Audio, AES Premiere Conference Rey, New York, Juni 1982.

Aus der EP-A-0 084 945 ist ein Verfahren und eine Vorrichtung zur digitalen Abtastratenwandlung bekannt. Darin wird das digitale Eingangssignal einer Abtastrate in einer speziellen Mutiplizieranordnung in ein digitales Signal mit einer vielfach höheren Abtastrate umgewandelt. Anschließend werden die Abtastwerte der Ausgangsabtastrate in einer Interpolatorschaltung aus den Abtastwerten mit der erhöhten Abtastrate gewonnen. Zur Interpolatorsteuerung werden Werte aus einer vorausberechneten Tabelle benutzt.

Der Erfindung liegt deshalb die Aufgabe zugrunde, ein Verfahren und eine Anordnung zur digitalen Abtastratenumsetzung zu schaffen, die sowohl das Verwenden einer niedrigen Umsetzzwischenfrequenz als auch das Umsetzen unterschiedlicher Abtastratenverhältnisse für universale Anwendungen mit geringem Aufwand ermöglichen.

Diese Aufgabe wird mit den in den Ansprüchen 1 und 5 angegebenen Mitteln gelöst. Vorteilhafte Weiterbildungen sind in den Unteransprüchen angegeben.

Dem Verfahren zur digitalen Abtastratenumsetzung eines digitalen Eingangssignals einer ersten Abtastrate in ein digitales Ausgangssignal einer zweiten Abtastrate liegt das Prinzip zugrunde, daß das digitale Ausgangssignal der zweiten Abtastrate mit einer Anzahl erster Zwischenwerte der ersten Abtastrate und das digitale Ausgangssignal bildenden zweiten Zwischenwerten innerhalb zweier erster Zwischenwerte gebildet wird. Aus dem Verhältnis zwischen einer zweiten Abtastrate und der ersten Abtastrate wird vorzugsweise ein Steuersignal gebildet, das sowohl zum Erzeugen eines Taktes der zweiten Abtastrate als auch zum Steuern eines linearen Interpolators verwendet wird. Dieses Steuersignal wird vorzugsweise mit einem Akkumulator gebildet, der als Eingangswert eine Zahl erhält, die dem Verhältnis der zweiten Abtastrate zur ersten Abtastrate entspricht. Zum Erzeugen eines Abstandsfaktors für den linearen Interpolator wird der Wert des Akkumulators in einem Multiplizierer mit einem Einstellwert verknüpft, der dem Verhältnis der ersten Abtastrate zur ausgangsseitigen Abtastrate entspricht. Global betrachtet, werden Datenwörter eines digitalen Eingangssignals mit einer ersten Abtastrate einem digitalen Interpolationsfilter zugeführt und mit dem digitalen Interpolationsfilter eine ganzzahlig vorgegebene Anzahl von ersten Zwischenwerten gebildet. Eine der vorgegebenen Anzahl entsprechende Anzahl von ersten Zwischenwerten innerhalb jeder Taktperiode der ersten Abtastrate wird dann einem linearen Interpolator zugeführt, mit dem aus zwei aufeinanderfolgenden ersten Zwischenwerten ein zweiter Zwischenwert, im der zweiten Abtastrate entsprechenden Raster, ermittelt wird. Ein den Zeitpunkt zum Bereitstellen des zweiten Zwischenwertes aus dem Verhältnis zwischen der ersten Abtastrate und der zweiten Abtastrate bestimmendes Steuersignal wird mit einer Interpolatorsteuerung als Abstandsfaktor gebildet. Aus dem von der Interpolatorsteuerung erzeugten Steuersignal wird weiterhin mit einem Taktgenerator ein Taktsignal der zweiten Abtastrate gebildet.

Als Anzahl von ersten Zwischenwerten wird vorzugsweise ein ganzzahliges Vielfaches von 128 und zum Realisieren des linearen Interpolators in vorteilhafter Weise ein serieller Multiplizierer durch Kombinieren der letzten Stufe des digitalen Interpolationsfilters mit dem linearen Interpolator verwendet.

Diese Anordnung zur digitalen Abtastratenumsetzung ist im wesentlichen dadurch gekennzeichnet, daß ein Taktsignal eines Vielfachen der ersten Abtastfrequenz führender erster Eingang des digitalen Abtastratenumsetzers mit allen Schaltungsteilen verbunden ist, und daß an dem ein digitales Eingangssignal der ersten Abtastrate führenden zweiten Eingang und an dem ein Taktsignal der ersten Abtastrate führenden dritten Eingang ein digitales Interpolationsfilter angeschlossen ist. Die Interpolatorsteuerung, an die der lineare Interpolator und der Taktgenerator für den ausgangsseitigen Takt angeschlossen sind, erhält einen Einstellwert, der dem Verhältnis der Abtastraten entspricht.

Der lineare Interpolator wird dabei durch Kombinieren der letzten Stufe des digitalen Interpolationsfilters mit dem linearen Interpolator vorzugsweise mit einem seriellen Multiplizierer gebildet.

Weiterhin werden mit dem Steuersignal der Interpolatorsteuerung zwei stabile Takte erzeugt, deren Frequenzen der zweiten Abtastrate und einem Vielfachen hiervon für eine AES/EBU Schnittstelle entsprechen, wodurch der zur Realisierung des Verfahrens erforderliche Aufwand verringert wird.

Insgesamt betrachtet, werden Datenwörter eines digitalen Eingangssignals mit einer ersten Abtastrate einem digitalen Interpolationsfilter zugeführt und mit dem digitalen Interpolationsfilter eine ganzzahlig vorgegebene Anzahl von ersten Zwischenwerten gebildet.

Der Eingangswert wird zusammen mit einer vorgegebenen Anzahl von Zwischenwerten innerhalb jeder Taktperiode der ersten Abtastrate einem linearen Interpolator zugeführt, mit dem aus zwei aufeinanderfolgenden ersten Zwischenwerten ein zweiter Zwischenwert innerhalb des der zweiten Abtastrate entsprechenden Rasters ermittelt wird. Der hierzu erforderliche Zeitpunkt zum Bereitstellen des zweiten Zwischenwertes wird aus dem Verhältnis zwischen der ersten Abtastrate und der zweiten Abtastrate bestimmt, das von einem mit einer Interpolatorsteuerung erzeugten Steuersignal repräsentiert wird. Dieses Steuersignal wird darüber hinaus einem Abtastratentaktgenerator zugeführt, mit dem ein Takt der zweiten Abtastrate, bzw. ein Vielfaches davon, erzeugt wird. Dabei kann in vorteilhafter Weise die letzten Stufe des digitalen Interpolationsfilters mit dem linearen Interpolator kombiniert werden und zum Realisieren des linearen Interpolators ein serieller Multiplizierer verwendet werden. Bei einer Anordnung zur Durchführung des Verfahrens ist der den Takt eines Vielfachen der ersten Abtastrate führende erste Eingang des digitalen Abtastratenumsetzers mit einem digitalen Interpolationsfilter, einer Interpolatorsteuerung mit der angeschlossenen Takterzeugung sowie dem Interpolator selbst verbunden. Zweite und dritte Eingänge, die Eingangsabtastwerte bzw. Datenwörter und einen zugehörigen Takt der ersten Abtastfrequenz führen, sind nur mit dem digitalen Interpolatiosfilter verbunden.

Der in einer Realisierung konstante Zahlenwert, der in dem digitalen Interpolationsfilter und in der Interpolatorsteuerung festgelegt ist, bestimmt die Anzahl der ersten Zwischenwerte. Die Interpolatorsteuerung enthält vorzugsweise einen Phasenakkumulator, mit dem aus einem Zahlenwert, der sich aus dem Verhältnis zwischen erster und zweiter Abtastrate sowie der Anzahl erster Zwischenwerte errechnet, ein Steuersignal sowohl für einen linearen Interpolator als auch für einen, den Takt der zweiten Abtastrate bereitstellenden Taktgenerator gebildet wird. Der lineare Interpolator ist durch Kombinieren mit der letzten Stufe des digitalen Interpolationsfilters in vorteilhafter Weise mit einem serieller Multiplizierer, der einen vergleichsweise geringeren Aufwand erfordert, realisierbar.

Es kommt ein digitales Interpolationsfilter zum Einsatz, welches zum Erhöhen der Abtastrate des Eingangssignals um einen ganzzahligen Faktor dient. Auf diese Weise erhält man eine Umsetzzwischenfrequenz, die vorzugsweise und vorteilhafterweise um einen ganzzahligen Faktor von 128 erhöht ist. Anschließend erzeugt ein linearer Interpolator zweite Ausgangssignalworte, die zeitlich im Raster der zweiten Abtastrate liegen, wobei nur noch zwei erste Zwischenwerte und der Zeitpunkt des benötigten Ausgangsabtastwertes zwischen diesen Werten zu berücksichtigen sind. Bei der Anordnung zur Durchführung des Verfahrens ist die Ausgangstakterzeugung bzw. das Erzeugen der zweiten Abtastrate mit in die Schaltungsanordnung integriert und es sind beliebige Verhältnisse zwischen Ausgangs- zum Eingangstakt bzw. Ausgangsabtastrate und Eingangsabtastrate wählbar, wodurch der digitale Abtastratenumsetzer in vorteilhafter Weise beispielsweise als Verbindungselement digitaler Audioschnittstellen unterschiedlicher Abtastfrequenz anwendbar ist.

Das Steuersignal des Akkumulators wird sowohl zum Ansteuern des Interpolators als auch zum Erzeugen des ausgangsseitigen Takts verwendet, wodurch nur eine relativ geringe Umsetzzwischenfrequenz erforderlich ist und der Ausgangstakt der zweiten Abtastrate kann über eine AES/EBU-Schnittstelle übertragen werden.

Nachfolgend wird die Erfindung anhand eines Ausführungsbeispiels in Zeichnungen erläutert.

Es zeigen:

Fig.1     Prinzipskizze eines Abtastprobendiagramms,
Fig.2     Blockschaltbild eines digitalen Abtastratenumsetzers,
Fig.3     Schaltungsskizze eines Schaltungsblocks eines digitalen Abtastratenumsetzers,
Fig.4     Taktsignaldiagramm,
Fig.5     Signaldiagramm zur Ausgangstakterzeugung.

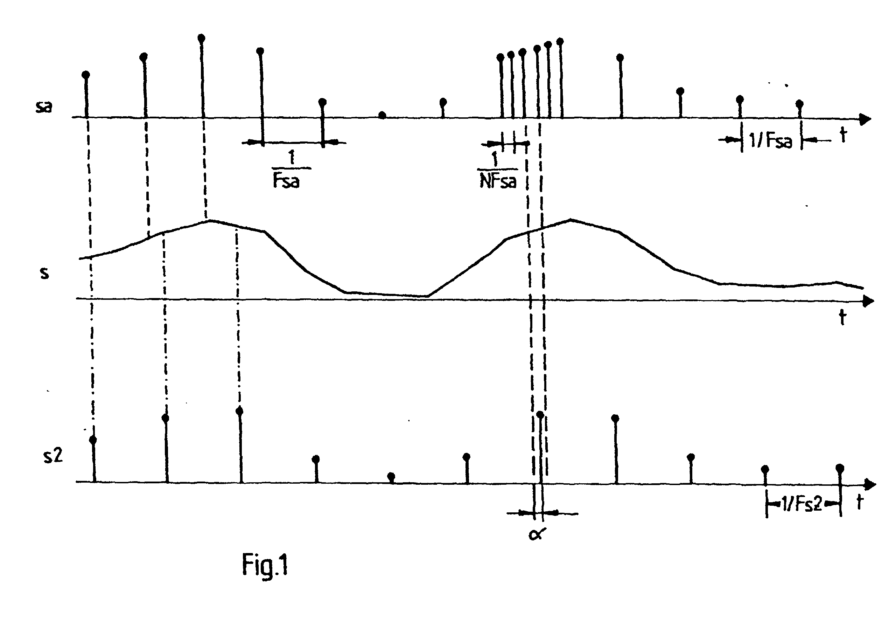

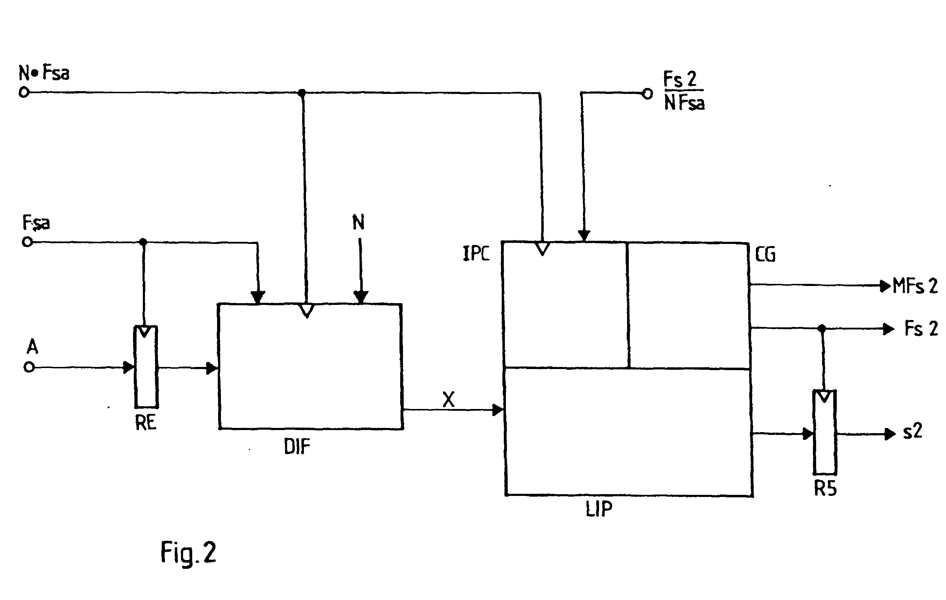

Gemäß dem in Fig.1 dargestellten Abtastprobendiagramm ist bei der digitalen Abtastratenumsetzung von einem digitalen Signal auszugehen, das aus Abtastproben sa besteht, die mit einer ersten Abtastrate Fsa auftreten. Diese Abtastproben sa sind beispielsweise einem analogen Signal s entnommen, das ein Audiosignal ist, und sind in ein Taktraster einer zweiten Abtastrate umzuwandeln, wobei die Abtastproben s2 der zweiten Abtastrate das analoge Signal s möglichst genau repräsentieren sollen. Die zweite Abtastrate besitzt die Frequenz Fs2. Zur digitalen Abtastratenumsetzung werden zunächst das Verhältnis zwischen der ersten Abtastrate und der zweiten Abtastrate gebildet bzw. eingestellt und der gewünschten Auflösung entsprechend eine festgelegte bzw. vorbestimmte Anzahl N erster Zwischenwerte innerhalb der ersten Abtastrate in bekannter Weise mit einem Interpolationsfilter DIF, das in Fig.2 dargestellt ist, gebildet. Wie dargestellt, sind dem Interpolationsfilter DIF die Abtastwerte eines Eingangssignals A über ein mit der Abtastfrequenz Fsa getaktetes Register RE zugeführt. Wie in der Prinzipskizze gemäß Fig.1 angegeben, führt dies zu ersten Zwischenwerten X, die mit dem N-fachen der ersten Abtastfrequenz Fsa auftreten, wobei die Zwischenwerte X den Ausgangsdatenstrom des in Fig.2 dargestellten digitalen Interpolationsfilters DIF repräsentieren. Als Anzahl N wird vorzugsweise ein ganzzahliges Vielfaches von 128 gewählt. Aus zwei aufeinanderfolgenden ersten Zwischenwerten X werden dann mit einem in Fig.2 dargestellten linearen Interpolator LIP zweite Zwischenwerte s2 gebildet, die Abtastproben s2 der zweiten Abtastrate mit der Abtastfrequenz Fs2 bzw. die Ausgangsabtastwerte sind. Die zweiten Zwischenwerte s2 werden entsprechend der Beziehung

$$s2[n] = (1-) * X[n-1] + * X[n]$$

gebildet, wobei der Zeitpunkt, für den ein zweiter Zwischenwert im Raster der zweiten Abtastfrequenz Fs2 benötigt wird, mit einer in Fig.2 dargestellten Interpolatorsteuerung IPC als Abstandszahl zwischen Null und Eins zum unmittelbar vorangehenden ersten Zwischenwert X[n-1] bestimmt und dem linearen Interpolator LIP zum Erzeugen des zweiten Zwischenwertes s2[n] aus zwei aufeinanderfolgenden ersten Zwischenwerten X[n-1] und X[n] zugeführt wird. Da entsprechend oben genannter Beziehung gegenüber dem ersten Zwischenwert X[n] lediglich die um den Faktor der Abstandszahl korrigierte Differenz zwischen einem ersten Zwischenwert X[n] und dem vorhergehenden ersten Zwischenwert X[n-1] zu berücksichtigen ist, kann zum Realisieren des Verfahrens in vorteilhafter Weise statt eines bisher notwendigen parallelen Multiplizierers ein serieller Multiplizierer verwendet werden. Weiterhin wird von der Interpolatorsteuerung IPC ein einen Takt der zweiten Abtastfrequenz Fs2 bereitstellender Abtastratentaktgenerator CG angesteuert, mit dem gleichzeitig ein m-faches der zweiten Abtastfrequenz Fs2 für eine AES/EBU-Schnittstelle erzeugt wird. Die Besonderheit besteht unter anderem darin, daß nicht unmittelbar vorhandene Takte der ersten und zweiten Abtastrate, sondern nur ein Takt und ein Zahlenwert, der dem Verhältnis der Abtastraten entspricht, als Ausgangspunkt zur Abtastratenumsetzung verwendet wird.

Gemäß dem in Fig.2 dargestellten Blockschaltbild eines digitalen Abtastratenumsetzers wird zunächst unabhängig vom zu realisierenderiverhältnis zwischen erster und zweiter Abtastrate eine feste Anzahl N erster Zwischenwerte X, die beispielsweise 256 beträgt, mit einem digitalen Interpolationsfilter DIF gebildet. Die Mehrzahl der Schaltungsteile wird zudem mit einem Takt betrieben, der in der Frequenz dem N-fachen der ersten Abtastfrequenz Fsa entspricht. Der Wert N ist sowohl bei der Realisierung des digitalen Interpolationsfilters DIF als auch einer Interpolatorsteuerung IPC zu berücksichtigen. Die Interpolatorsteuerung IPC ist als Bestandteil eines Schaltungsblockes dargestellt, der weiterhin einen linearen Interpolator LIP und einen Abtastratentaktgenerator CG enthält, um besonders deutlich zu machen, daß die Verknüpfung dieser Bestandteile für das Grundprinzip der Lösung und einen geringen Aufwand wesentlich sind. Mit diesem Schaltungsblock, dem die ersten Zwischenwerte X, ein Takt, der in der Frequenz der um eine Anzahl N vervielfachten ersten Abtastfrequenz Fsa entspricht, und das Verhältnis zwischen erster und zweiter Abtastrate Fs2/Fsa zugeführt wird, werden sowohl ein Takt der zweiten Abtastrate Fs2 als auch zweite Zwischenwerte s2 als Abtastproben im ausgangsseitigen Taktraster erzeugt.

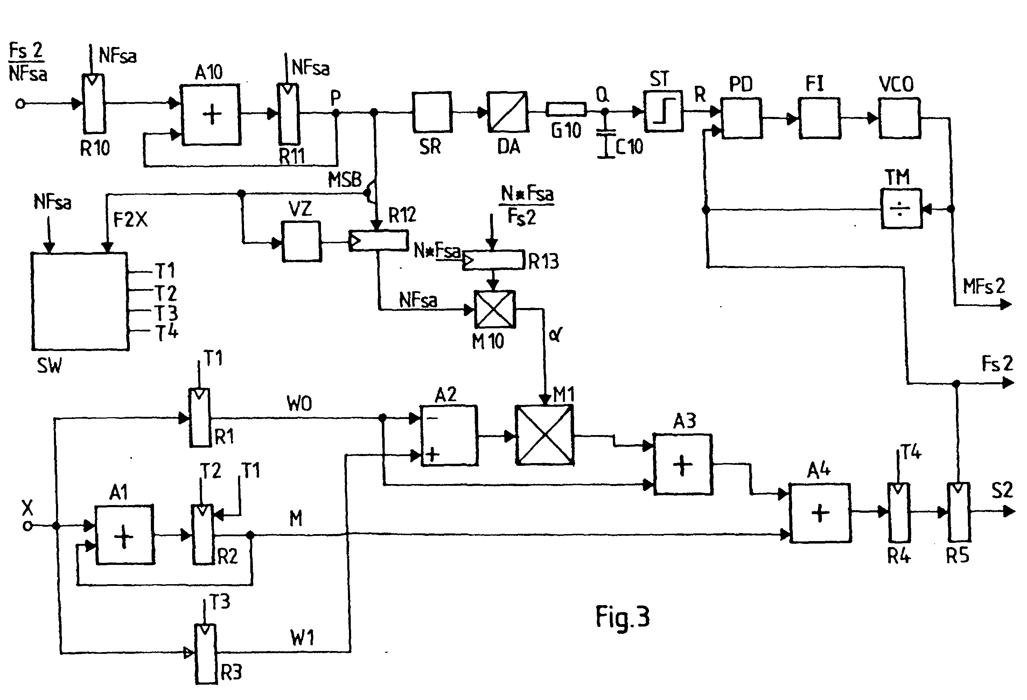

Dies erfolgt, wie eine in Fig.3 dargestellte Schaltungsanordnung dieses Schaltungsblocks zeigt, mit geringem Aufwand und hoher Genauigkeit, da Störungen weitestgehend unterdrückt werden und obwohl das Verhältnis zwischen erster und zweiter Abtastrate den Erfordernissen entsprechend frei gewählt werden kann.

Es werden eine vergleichsweise geringere Anzahl von Zwischenwerten X benötigt und eine hohe Genauigkeit im Vergleich mit dem Ursprungs- bzw. analogen Signal s erreicht. Im Einzelnen enthält die Fig.3 entsprechende Schaltungsanordnung des in Fig.2 dargestellten Schaltungsblocks ein erstes Register R10, dem das Verhältnis zwischen der zweiten Abtastrate Fs2 und der ersten Abtastrate Fsa multipliziert mit dem reziproken Wert der gewählten Anzahl N erster Zwischenwerte von z.B. 256 zugeführt wird.

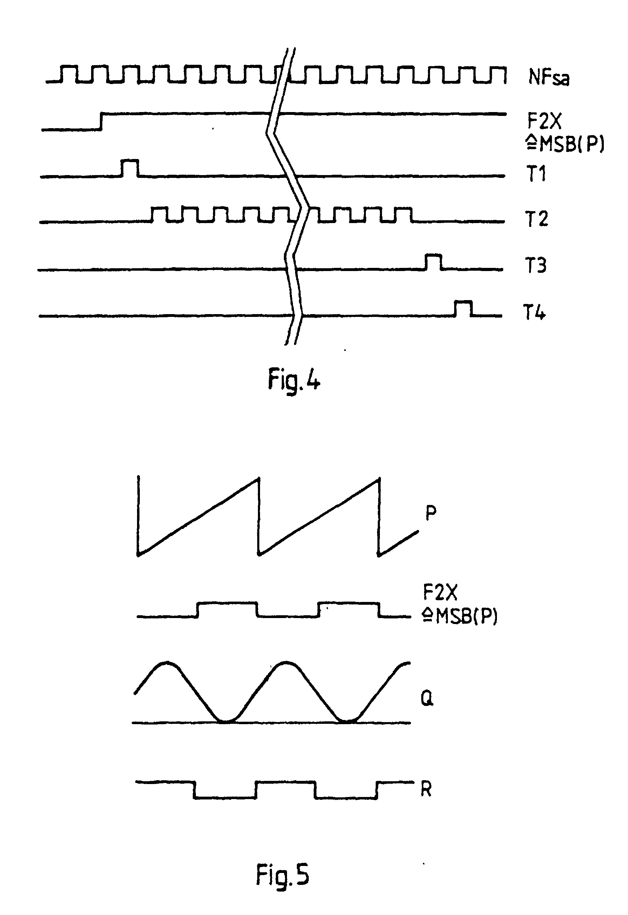

Am ersten Register R10 ist ein Akkumulator angeschlossen, der von einem Addierer A10 und einem Register R11 gebildet wird. Das erste Register R10 und das Register R11 bzw. der Akkumulator werden mit dem Takt des N-fachen der ersten Abtastfrequenz Fsa getaktet, so daß mit jedem Takt ein Ausgangswert des Akkumulators um den Wert des ersten Registers R10 erhöht wird. Dies führt dazu, daß der Akkumulator von Zeit zu Zeit überläuft und die Wertefolge am Ausgang des Akkumulators als äquidistante Punkte auf einem Sägezahn aufgefaßt werden kann. Der im Register R10 abgelegte Wert bestimmt dann die Steilheit des Sägezahns, der als Steuersignal P sowohl für den linearen Interpolator LIP als auch für einen die zweite Abtastfrequenz Fs2 bereitstellenden Abtastratentaktgenerator CG verwendet wird und in Fig.5 dargestellt ist. Insbesondere zum Steuern des linearen Interpolators LIP wird eine Reihe von Taktsignalen benötigt, die mit dem Most Significant Bit MSB des Steuersignals P und dem Takt des Vielfachen der ersten Abtastfrequenz N*Fsa gebildet werden. Hierzu wird das Most Significant Bit MSB, das als Signal F2X in Fig.5 dargestellt ist, sowohl einem Steuerwerk SW zum Erzeugen von Taktsignalen T1 bis T4 als auch über eine Verzögerungseinheit VZ dem Takteingang eines Registers R12 zugeführt. In das am Ausgang des Akkumulators angeschlossene Register R12 wird dann ein mittleres Bitfeld des Wortes des Steuersignals P mit einer ansteigenden Flanke des Signals F2X übernommen, das in einem daran angeschlossenen Multiplizierer M10 mit dem Ausgabesignal eines Registers R13 zum Erzeugen der Abstandszahl α multipliziert wird. Hierzu wird dem Register R13, das mit dem Takt der Frequenz N*Fsa getaktet wird, ein Einstellwert zugeführt, der dem Produkt von Fsa und N, dividiert durch Fs2 entspricht.

Der Inhalt von Register R13 ist praktisch reziprok zum Inhalt von Register R10. Diese Abstandszahl α wird dann im linearen Interpolator LIP zum Bereitstellen zweiter Zwischenwerte s2, die den Ausgangswerten der zweiten Abtastrate entsprechen, verwendet. Wie bereits erläutert, werden dem linearen Interpolator LIP kontinuierlich erste Zwischenwerte X vom digitalen Interpolationsfilter DIF zugeführt. Diese Darstellung wurde zur Vereinfachung und einer besseren Übersicht gewählt. Es ist zutreffend, daß vom digitalen Interpolationsfilter DIF erste Zwischenwerte X bereitgestellt werden, wobei in dieser Ausführung die letzte Stufe des digitalen Interpolationsfilters DIF einen Addierer A1 und drei Register R1,R2,R3 enthält, die in Fig.3 dargestellt sind. In der letzten Stufe des digitalen Interpolationsfilters DIF werden die ersten Zwischenwerte X als eine Folge von Datenworten mit dem Takt des Vielfachen der ersten Abtastfrequenz N*Fsa unmittelbar einem Addierer A1 und zwei Registern R1,R3 zugeführt. Anhand des in Fig.4 dargestellten Taktsignaldiagramms, welches den Takt des Vielfachen der ersten Abtastfrequenz N*Fsa, das Signal F2X als höchstwertiges Bit MSB des Phasenwertes P und die Taktsignale T1 bis T4 zeigt, wird deutlich, daß nach einer ansteigenden Flanke des Signals F2X mit dem Taktsignal T1 im Register R1 ein erster Zwischenwert X, der einen Wert WO aufweist, gespeichert wird. Gleichzeitig wird das Register R2, das dem Addierer A1 nachgeschaltet ist und mit diesem einen Akkumulator bildet, mit dem Taktsignal T1 zurückgesetzt. Nach dem Taktsignal T1 wird dann das Register R2 mit dem Taktsignal T2, das beispielsweise aus 32 Impulsen besteht, getaktet, wodurch nach Ende der Taktfolge ein Wert M am Ausgang des Registers R2 bereitgestellt wird. Im Register R2 liegt dann die Summe aus fortlaufenden Zwischenwerten X, welche die Reihenfolge 2 bis 33 aufweisen. Nach 33 Impulsen der Taktsignale T1 und T2 folgt dann im Taktsignal T3 ein einzelner 34-ster Impuls, mit dem dann im Register R3 ein Wert W1 abgelegt wird. Mit der letzten Stufe des digitalen Interpolationsfilters DIF ist ein Filter realisiert, das kontinuierlich die Summe aus 33 Zwischenwerten X erzeugt, und das auch als sogenanntes MTA-Filter bezeichnet wird (Moving Time Averager).

Mit den linearen Interpolator LIP, der im wesentlichen drei Addierer A2,A3,A4 und einen seriellen Multiplizierer M1 enthält, werden die Werte WO,M und W1 der Zwischenwerte X dann derart verarbeitet, daß der mit dem Taktsignal T1 übernommene Wert WO und der mit dem Taktsignal T3 übernommene Wert W1 dem Addierer A2 zugeführt werden, an dem der serielle Multiplizierer M1 zur Multiplikation mit dem Abstandsfaktor α angeschlossen ist. Der Ausgang des seriellen Multiplizierers M1 ist mit dem Addierer A3 verbunden, dem auch der jeweilige Wert WO zugeführt wird und am Ausgang dieses Addierers A3 ist der Addierer A4 angeschlossen, mit dem die Werte M hinzugefügt werden.

Der lineare Interpolator genügt der folgenden Formel.

$$s2[n] = (1-\alpha) * Y[n-1] + \alpha * Y[n]$$

Für α=1 wird der Wert X[n] gewählt, für α=0 der Wert X[n-1]. Für Werte zwischen 0 und 1 werden entsprechende Zwischenwerte berechnet.

Dem linearen Interpolator ging ein MTA Filter voraus, das einen Wert Y[n] durch Aufaddition der jeweils letzten 33 empfangenen X Werte berechnet. Y[1] könnte also die Summe der X[1] ... X[33] sein. Der nächste Wert Y[2] ist dann die Summe der X[2] ... X[34]. Man erkennt, Y[1] und Y[2] haben die X[2] ... X[33] als gemeinsamen Anteil. Demnach kann man diesen Anteil, dem in Fig.3 das Signal M entspricht, aus der Umblendrechnung des linearen Interpolators herausnehmen. Die erfolgt dann nur noch mit X[1] und X[34], denen in Fig.3 dann W0 und W1 entsprechen. Nach Ändern der Klammerung in der obigen Gleichung wird dann die Struktur in Fig.3 erkennbar.

$$s2[n] = W0 + \alpha*(W1-W0) + M$$

Mit einem Register R4 wird dann der derart gebildete zweite Zwischenwert s2 mit einem Taktsignal T4 gespeichert und in ein Register R5 übernommen, das mit der zweiten Abtastfrequenz Fs2 bzw. der zweiten Abtastrate getaktet wird. Das Taktsignal T4 und der Takt der zweiten Abtastfrequenz Fs2 unterscheiden sich lediglich in der Phasenlage und durch ein Jitter, so daß mit dieser Maßnahme das Ausgangsdatenwort selbst unverändert bleibt, und elektrisch nur an das mit dem ausgangsseitigen Abtastraster verkoppelte Taktsystem übergeben wird. Als Takt der zweiten Abtastfrequenz Fs2 wird nicht ein Signal von einem anzuschließenden Gerät unmittelbar verwendet, sondern der Takt der zweiten Abtastfrequenz Fs2 wird in der Schaltungsanordnung aus dem Verhältnis der eingangs- und ausgangsseitigen Abtastraten mit dem Steuersignal P und dem eingangsseitigen Takt N*Fsa gebildet. Hierzu wird das sägezahnförmige Steuersignal P Fig.5 entsprechend als Phasenwert im Bereich von Null bis 2 π interpretiert. Gemäß Fig.5 wird dieser Wert P einer Sinustabelle SR zugeführt und die sich so ergebende Folge von Sinuswerten in eine Analogspannung gewandelt, die am Kondensator C10 anliegt. Zur Unterdrückung von hochfrequenten Anteilen bzw. Störbefreiung folgt dem DA/Umsetzer ein RC Tiefpaß bestehend aus G10 und C10. Die Phase dieser Sinusspannung Q ist durch den Wert P vorgeben. Die Frequenz ergibt sich aus dem Wert von Register R10 und der Frequenz des Taktes N*Fsa. Aus der Sinusspannung Q erzeugt ein Schmitt-Trigger ST dann wieder ein Rechtecksignal R, das nun nicht mehr phasendiskret mit der ersten Abtastfrequenz Fsa verbunden ist, sondern die zweite Abtastfrequenz Fs2 bereitstellt. Mittels einer Vervielfacher-PLL, die aus einem Phasendetektor PD, einem Schleifenfilter FI, einem spannungsgesteuerten Oszillator VCO und einem Teiler TM besteht, wird das Rechtecksignal R von Störungen befreit. Mit dem Teiler TM ergibt sich in vorteilhafter Weise auch ein Takt eines Vielfachen der zweiten Abtastfrequenz Fs2 für eine Schnittstellenversorgung. Die zweite Abtastfrequenz Fs2 ist im Fall der gerasteten Vervielfacher-PLL nahezu identisch mit dem Rechtecksignal R, jedoch aufgrund der Filterwirkung der Vervielfacher-PLL weniger mit Störgrößen behaftet.

Der beschriebene digitale Abtastratenumsetzer ermöglicht in vorteilhafter Weise das Umsetzen digitaler Abtastraten bei freier Wählbarkeit der Ausgangs- bzw. zweiten Abtastrate durch Einstellen oder Vorgabe des Verhältnisses der Abtastraten mit einer vergleichsweise relativ geringen Umsetzzwischenfrequenz auch bei ungünstigen Abtastratenverhältnissen mit geringem Aufwand.

**Patentansprüche**

1.　Verfahren zur digitalen Abtastratenumsetzung eines digitalen Eingangssignals einer ersten Abtastrate (Fsa) in ein digitales Ausgangssignal einer zweiten Abtastrate (Fs2), wobei folgende Schritte ausgeführt werden:

es werden zunächst mit einem digitalen Interpolationsfilter (DIF) erste Zwischenwerte (X) zu den Abtastwerten des Eingangssignals erzeugt, die mit einer N-fach höheren Rate als die erste Abtastrate (Fsa) auftreten, wobei N eine natürliche Zahl größer als 1 ist, und dann wird aus zwei benachbarten Zwischenwerten mittels eines linearen Interpolators (LIP), unter Verwendung eines Abstandsfaktor ($\alpha$), der den Abstand des Abtastwertes in dem zweiten Raster zu einem der benachbarten Zwischenwerte angibt, ein Abtastwert für das zweite Abtastraster ermittelt, wobei der berechnete Abtastwert mit Hilfe eines Taktgenerators (CG) für einen gewählten Ausgangstakt bzw. eine gewählte Zielfrequenz, zeitrichtig am Ausgang bereitgestellt wird, **dadurch gekennzeichnet, daß** der Abstandsfaktor ($\alpha$) in einer Interpolatorsteuerung (IPC) aus dem Verhältnis zwischen der zweiten Abtastrate (Fs2) und dem N-fachen der ersten Abtastrate (Fsa) als Eingangswert mittels eines Akkumulators (A10, R11) und einer nachgeschalteten Multiplizierstufe (M10) berechnet wird.

2.　Verfahren nach Anspruch 1, **dadurch gekennzeichnet, daß** aus dem Verhältnis zwischen einer zweiten Abtastfrequenz (Fs2) der zweiten Abtastrate und einer ersten Abtastfrequenz (Fsa) der ersten Abtastrate ein Steuersignal (P) gebildet wird, das sowohl zum Erzeugen eines Taktes der zweiten Abtastfrequenz (Fs2) als auch zum Steuern des linearen Interpolators (LIP) verwendet wird.

3.　Verfahren nach Anspruch 1 oder 2, **dadurch gekennzeichnet, daß** in der Multiplizierstufe (M10) der Wert in dem Akkumulator (A10, R11) mit einem Wert verknüpft wird, der dem Verhältnis des N-fachen der ersten Abtastrate (Fsa) zur zweiten Abtastrate (Fs2) entspricht.

4.　Verfahren nach einem der Ansprüche 1 bis 3, **dadurch gekennzeichnet, daß** als ganzzahlig vorgegebene Anzahl (N) von ersten Zwischenwerten (X) ein ganzzahliges Vielfaches von 128 verwendet wird.

5. Anordnung zur digitalen Abtastratenumsetzung eines digitalen Eingangssignals einer ersten Abtastrate (Fsa) in ein digitales Ausgangssignal einer zweiten Abtastrate (Fs2), wobei ein erstes digitales Interpolationsfilter (DIF) vorgesehen ist, das erste Zwischenwerte (X) zu den Abtastwerten des Eingangssignals erzeugt, die mit einer N-fach höheren Rate als die erste Abtastrate (Fsa) auftreten, wobei N eine natürliche Zahl größer als 1 ist, wobei weiterhin eine Interpolatorsteuerung (IPC) vorgesehen ist, in der für die Position eines Abtastwertes in dem zweiten Abtastraster ein Abstandsfaktor ($\alpha$) bestimmt wird, der den Abstand des Abtastwertes in dem zweiten Raster zu einem der benachbarten Zwischenwerte angibt, daß ein linearer Interpolator (LIP) vorgesehen ist, dem die berechneten Zwischenwerte (X) zugeführt werden und der aus zwei benachbarten Zwischenwerten einen Abtastwert in dem zweiten Raster mittels des von der Interpolatorsteuerung (IPC) zugeführten Abstandsfaktors ($\alpha$) interpoliert, wobei ein Taktgenerator (CG) vorgesehen ist, zum Bereitstellen des Ausgangstaktes für die zweite Abtastrate um die interpolierten Abtastwerte in dem zweiten Abtastraster zeitrichtig auszugeben, **dadurch gekennzeichnet, daß** in der Interpolatorsteuerung (IPC) zur Berechnung des Abstandsfaktors ($\alpha$) ein Akkumulator (A10, R11) vorgesehen ist, dem das Verhältnis zwischen der zweiten Abtastrate (Fs2) und dem N-fachen der ersten Abtastrate (Fsa) als Eingangswert zugeführt ist, und daß dem Akkumulator (A10, R11) eine Multiplizierstufe (M10) nachgeschaltet ist, in der der Wert des Akkumulators mit dem umgekehrten Verhältnis zwischen der zweiten Abtastrate (Fs2) und dem N-fachen der ersten Abtastrate (Fsa) multipliziert wird.

## Claims

1. Method for the digital conversion of the sampling rate of a digital input signal having a first sampling rate (Fsa) into a digital output signal having a second sampling rate (Fs2), wherein the following steps are executed:

    first of all first intermediate values (X) are generated for the sampling values of the input signal by means of a digital interpolation filter (DIF), said intermediate values (X) appearing with a rate being by an Nth-multiple higher than said first sampling rate (Fsa), wherein N is a natural number higher than 1, and then a sampling value for the second scanning raster is determined from two adjacent intermediate values by means of a linear interpolator (LIP) by using a spacing factor (?) indicating the spacing of the sampling value within the second raster with respect to one of the adjacent intermediate values, wherein the calculated sampling value is provided in correct time at the output by means of a clock generator (CG) for a selected output clock and a selected target frequency, respectively,

    **characterized in that**,
    the spacing factor (?) is calculated within an interpolator control (IPC) from the ratio between the second sampling rate (Fs2) and the Nth-multiple of the first sampling rate (Fsa) as input value by means of an accumulator (A10, R11) and a downstream connected multiplier stage (M10).

2. Method according to claim 1, **characterized in that** a control signal (P) is formed from the ratio between a second sampling frequency (Fs2) having the second sampling rate and a first sampling frequency (Fsa) having the first sampling rate, said control signal being used both for generating a clock having the second sampling rate (Fs2) and for controlling the linear interpolator (LIP).

3. Method according to claim 1 or 2, **characterized in that** within the multiplier stage (M10) the value within the accumulator (A10, R11) is linked with a value corresponding to the ratio of the Nth-multiple of the first sampling rate (Fsa) with respect to the second sampling rate (Fs2).

4. Method according to anyone of claims 1 to 3, **characterized in that** an integer multiple of 128 is used as integer predetermined number (N) of first intermediate values (X).

5. Arrangement for the digital conversion of the sampling rate of a digital input signal having a first sampling rate (Fsa) into a digital output signal having a second sampling rate (Fs2), wherein a first digital interpolation filter (DIF) is provided generating first intermediate values (X) for the sampling values of the input signal appearing at an Nth-multiple higher rate than the first sampling rate (Fsa), N being a natural number higher than 1, wherein furthermore an interpolator control (IPC) is provided, wherein a spacing factor (?) is determined for the position of a sampling value within the second sampling raster indicating the spacing of the sampling value within the second raster with respect to one of the adjacent intermediate values, that a linear interpolator (LIP) is provided which is fed by the calculated intermediate values (X) and which interpolates from two adjacent intermediate values a sampling value within the second raster by means of the spacing factor (?) supplied by the interpolator control (IPC), wherein a clock generator (CG) is provided for providing the output clock for the second sampling rate in order to output the interpolated sampling values within the second sampling raster in correct time, **characterized in that** an accumulator (A10, R11) is provided within the interpolator control (IPC) for calculating the spacing factor (?) with is fed by the ratio between the second sampling rate (Fs2) and the Nth-multiple of the first sampling rate (Fsa) as input value, and that a multiplier stage (M10) is provided downstream to the accumulator (A10, R11), wherein the value of the accumulator is multiplied by the inversed ratio between the second sampling rate (Fs2) and the Nth-multiple of the first sampling rate (Fsa).

**Revendications**

1. Procédé de conversion pour échantillonnage numérique d'un signal d'entrée numérique d'un premier taux d'échantillonnage (Fsa) en un signal de sortie numérique d'un second taux d'échantillonnage (Fs2), où la procédure suivante est réalisée :

les premières valeurs intermédiaires (X) sont tout d'abord produites avec un filtre d'interpolation numérique (DIF) en valeurs d'échantillonnage du signal d'entrée qui apparaissent avec un taux n fois supérieur au premier taux d'échantillonnage (Fsa), où N est un entier naturel supérieur à 1, puis une valeur d'échantillonnage est calculée pour la seconde trame d'échantillonnage, à partir de deux valeurs intermédiaires voisines, grâce à un interpolateur linéaire (LIP), en utilisant un facteur d'écart ($\alpha$) qui indique l'écart de la valeur d'échantillonnage dans la seconde trame par rapport à l'une des valeurs intermédiaires voisines, où la valeur d'échantillonnage calculée est fournie à l'aide d'un générateur d'impulsions (CG), pour une impulsion de sortie ou une fréquence cible choisie, au moment adéquat, à la sortie, **caractérisé en ce que** le facteur d'écart ($\alpha$) dans une commande d'interpolateur (IPC) est calculé à partir du rapport entre le second taux d'échantillonnage (Fs2) et le multiple du premier taux d'échantillonnage (Fsa), en tant que valeur d'entrée, à l'aide d'un accumulateur (A10, R11) et d'un étage multiplicateur (M10) placé en aval.

2. Procédé conforme à la revendication 1, **caractérisé en ce qu'**un signal de commande est constitué à partir du rapport entre une seconde fréquence d'échantillonnage (Fs2) et une première fréquence d'échantillonnage (Fsa) du premier taux d'échantillonnage, et ce signal est utilisé pour produire une impulsion de la seconde fréquence d'échantillonnage (Fs2) et pour commander l'interpolateur linéaire (LIP).

3. Procédé conforme à la revendication 1 ou 2, **caractérisé en ce que**, dans l'étage multiplicateur (M10), la valeur de l'accumulateur (A10, R11) est reliée à une valeur qui correspond au rapport entre le multiple du premier taux d'échantillonnage (Fsa) et le second taux d'échantillonnage (Fs2).

4. Procédé conforme aux revendications 1 à 3, **caractérisé en ce qu'**un multiple entier de 128 est utilisé comme nombre défini comme entier (N) des premières valeurs intermédiaires (X).

5. Aménagement pour la conversion pour échantillonnage numérique d'un signal d'entrée numérique en un signal de sortie numérique d'un second taux d'échantillonnage (Fs2), où un premier filtre d'interpolation numérique (DIF) est prévu pour produire les premières valeurs intermédiaires (X) en valeurs d'échantillonnage du signal d'entrée qui apparaissent avec un taux n fois supérieur au premier taux d'échantillonnage (Fsa), où N est un entier naturel supérieur à 1, où une commande d'interpolateur (IPC) est ensuite prévue pour y définir un écart ($\alpha$) de la position d'une valeur d'échantillonnage dans la seconde trame d'échantillonnage, facteur d'écart qui indique l'écart de la valeur d'échantillonnage dans la seconde trame par rapport à l'une des valeurs intermédiaires voisines, en ce qu'un interpolateur linéaire (LIP) est prévu et dans lequel les valeurs intermédiaires (X) calculées sont acheminées, qui effectue l'interpolation, à partir de deux valeurs intermédiaires voisines, d'une valeur d'échantillonnage dans la seconde trame, à l'aide du facteur d'écart acheminé par la commande d'interpolateur (IPC), où un générateur d'impulsions (CG) est prévu pour fournir l'impulsion de sortie pour le second taux d'échantillonnage (Fs2), afin de produire les valeurs d'échantillonnage interpolées dans la seconde trame d'échantillonnage, au moment adéquat, **caractérisé en ce qu'**un accumulateur (A10, R11) est prévu dans la commande d'interpolateur (IPC) pour calculer le facteur d'écart ($\alpha$), accumulateur auquel est acheminé en tant que valeur d'entrée le rapport entre le second taux d'échantillonnage (Fs2) et le multiple du premier taux d'échantillonnage (Fsa), et **en ce qu'**un étage multiplicateur est placé en aval de l'accumulateur (A10, R11), étage dans lequel la valeur de l'accumulateur est multipliée par le rapport inverse entre le second taux d'échantillonnage (Fs2) et le multiple du premier taux d'échantillonnage (Fsa).

Fig.1

sa

$\dfrac{1}{Fsa}$

$\dfrac{1}{NFsa}$

1/Fsa      t

s      t

s2      1/Fs2      t

α

EP 0 639 906 B1

N• Fsa

Fsa

N

$\dfrac{Fs\,2}{N\,Fsa}$

A

RE

DIF

X

IPC

CG

LIP

MFs 2

Fs 2

R5

s2

Fig.2

Fig.3

NFsa

F2X
≙MSB(P)

T1

T2

T3

T4

Fig.4

P

F2X
≙MSB(P)

Q

R

Fig.5